# EUROPEAN PATENT APPLICATION

(11) **EP 4 685 501 A1**
(43) Date of publication of application: **28.01.2026**
(21) Application number: 25191797.7
(22) Date of filing: 25.07.2025
(51) Int. Cl.: G01R 31/28

(54) **ARC SUPPRESSION IN A WAFER TESTING ENVIRONMENT**

(30) Priority: 26.07.2024 US 202463675872 P
(71) Applicant: Celadon Systems, Inc., Burnsville, MN 55337 (US)
(72) Inventor: Roehl, Dalton, Burnsville, Minnesota 55337 (US); Tranquillo, Garrett, Burnsville, Minnesota 55337 (US); Schisel, Nicholas, Burnsville, Minnesota 55337 (US); Winship, Daniel, Burnsville, Minnesota 55337 (US)
(74) Representative: Meissner Bolte Partnerschaft mbB

(57) **Abstract**

Testing performance of a semiconductor device includes redirecting a heated gas from an external source into a closed probe card assembly via a rigid gas manifold to create a pressurized region proximate to a device under test (DUT) and returning a sampling of the heated gas from the pressurized region to a controller device external to the closed probe assembly via a rigid return gas manifold. The heated gas is injected within a range of pressure and temperature to increase arc suppression on the DUT, and the pressure and the temperature of the heated gas is monitored at the controller.

## Description

### TECHNICAL FIELD

This disclosure generally relates to test equipment and systems for a device under test, including, but not limited to, a semiconductor device. More specifically, this disclosure relates to systems and apparatuses by which arc suppression is implemented without interrupting or disrupting the testing environment for a semiconductor wafer or a micro-electrical-mechanical systems (MEMS) device.

### BACKGROUND

As semiconductor technology evolves and the devices in which semiconductors are deployed decrease in size but increase in complexity, it is imperative to test the performance of the semiconductors and their on-wafer electrical interconnects for breakdown voltages, leakage currents, and low operating currents while the devices are in wafer form. In addition, the currents and device characteristics are often required to be evaluated over a wide temperature and voltage range to understand how temperature and voltage affects a device. Also, due to continuous and rapid changes in semiconductor technology, the size of semiconductor devices and their electrical contact pads keeps getting smaller.

### SUMMARY

In one example embodiment, a wafer test assembly includes a probe card assembly, a rigid gas manifold, and a rigid return gas manifold. The probe card assembly includes a probe tile that is configured to accommodate a plurality of openings through which a plurality of voltage-charged probe wires extend, a seal disposed on a surface of the probe tile configured to form a pressurized area over at least the probe tile, and a cap configured to securely cover the probe card assembly. The cap includes a gas inlet that is configured to conduit gas into the pressurized area via the plurality of openings of the probe tile, and a gas return outlet that is configured to conduit pressurized gas from the pressurized area. The rigid gas manifold is configured to connect to the gas inlet to redirect gas from a gas heater assembly to the pressurized area, and the rigid return gas manifold is configured to connect to the gas return outlet to return a sampling of the pressurized gas from the pressurized area to the gas heater assembly.

In accordance with at least one other example embodiment, a method of testing performance of a semiconductor device includes redirecting a heated gas from an external source into a closed probe card assembly via a rigid gas manifold to create a pressurized region proximate to a device under test (DUT) and returning a sampling of the heated gas from the pressurized region to a controller device external to the closed probe assembly via a rigid return gas manifold. The heated gas is injected within a range of pressure and temperature to increase arc suppression on the DUT, and the pressure and the temperature of the heated gas is monitored at the controller.

### BRIEF DESCRIPTION OF THE DRAWINGS

In the detailed description that follows, embodiments are described as illustrations only since various changes and modifications will become apparent to those skilled in the art from the following detailed description. The use of the same reference numbers in different figures indicates similar or identical items.
FIGS. 1A and 1B show a partial view of at least some features of a wafer test assembly, in accordance with a non-limiting example embodiment as described and recited herein.
FIG. 1C shows a top view of a wafer test assembly, in accordance with a non-limiting example embodiment as described and recited herein.
FIG. 1D shows a side view of a wafer test assembly, in accordance with a non-limiting example embodiment as described and recited herein.
FIGS. 2A and 2B show views of a probe card assembly, in accordance with a non-limiting example embodiment as described and recited herein.
FIGS. 3A and 3B show sample views of a manifold, in accordance with a non-limiting example embodiments as described and recited herein.

### DETAILED DESCRIPTION

In the following detailed description, reference is made to the accompanying drawings, which form a part of the description. In the drawings, similar symbols typically identify similar components, unless context dictates otherwise. Furthermore, unless otherwise noted, the description of each successive drawing may reference features from one or more of the previous drawings to provide clearer context and a substantive explanation of the current example embodiment. Still, the example embodiments described in the detailed description, drawings, and claims are not intended to be limiting. Other embodiments may be utilized, and other changes may be made, without departing from the spirit or scope of the subject matter presented herein. It will be readily understood that the aspects of the present disclosure, as generally described and recited herein, as well as illustrated in the drawings, may be arranged, substituted, combined, separated, and designed in a wide variety of different configurations, all of which are explicitly contemplated herein.

Additionally, portions of the present disclosure may be described herein in terms of functional block components and various processing steps. It should be appreciated that such functional blocks may be realized by any number of hardware and/or software components configured to perform the specified functions.

In the present description and recitation, the following terms may be used, in addition to their accepted meaning, as follows.

Rigid, as disclosed, recited, or otherwise referenced herein, refers to a construction of a manifold, conduit, and/or tubing that does not flex, bend, or is otherwise forced out of shape under the influence of a heated and/or pressurized gas passing therethrough.
manifold 300 is configured as a conduit composed of a rigid material, *i.e.,* copper, having strong heat stability that is to facilitate the redirection of heated and/or pressurized air

Arc discharge or electric arc is a continuous arc-discharge consisting of highly energized electrons and ions supported by an electric current, *e.g.,* at least 100mA. Accordingly, arc suppression, as referenced herein, refers to the reduction of electric arc energy that occurs when current-carrying contacts are opened and closed in the wafer testing environment. In the absence of arc suppression in accordance with the embodiments described and recited herein, effective testing of the semiconductor device, *i.e.,* wafer, is increasingly difficult. For example, the determination and/or confirmation of a breakdown voltage of the semiconductor device.

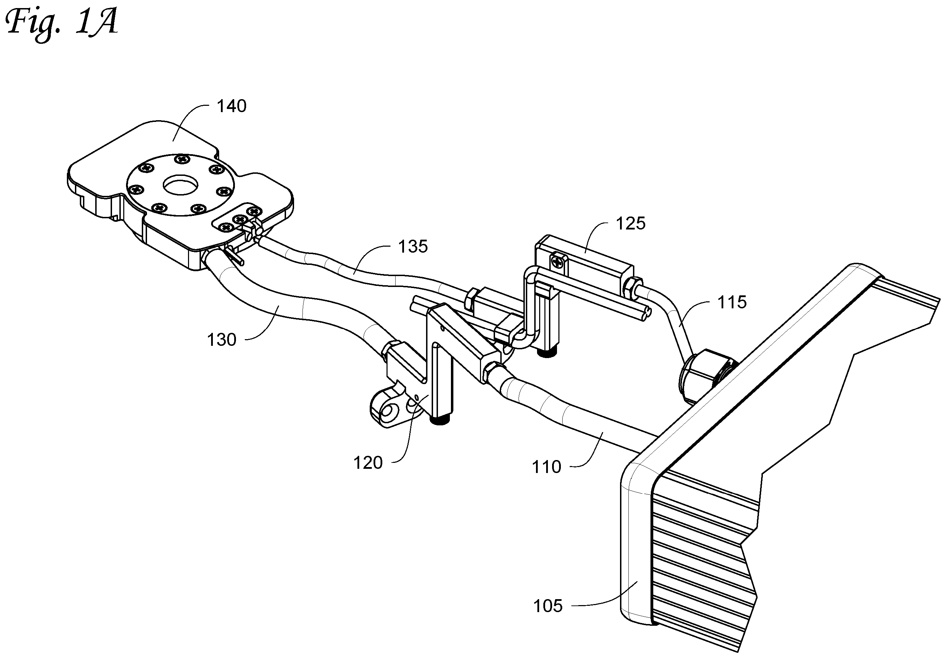

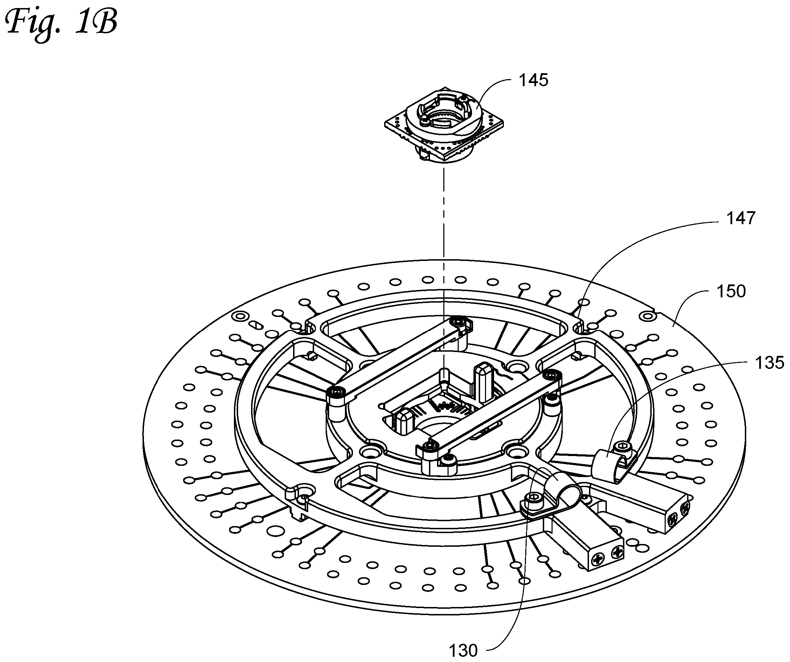

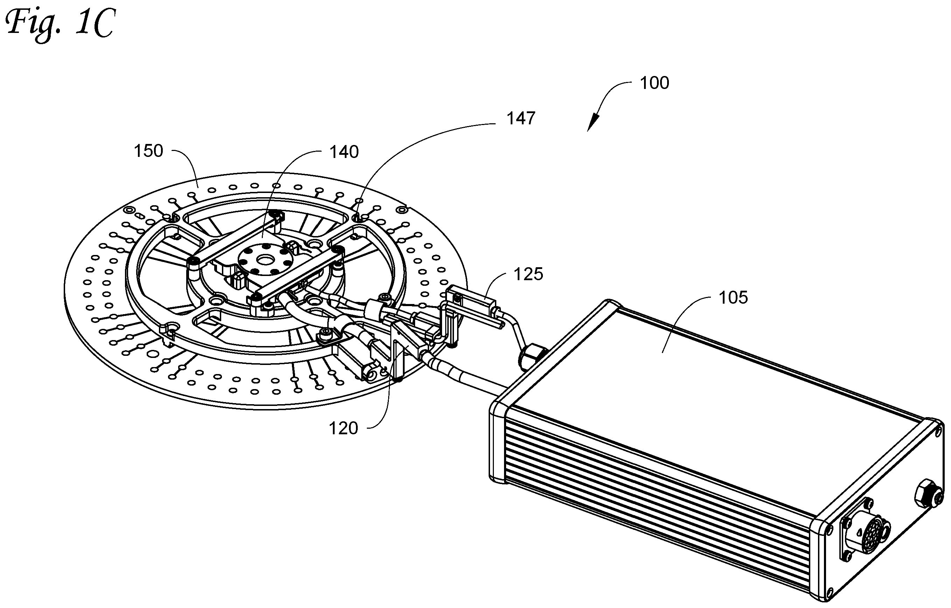

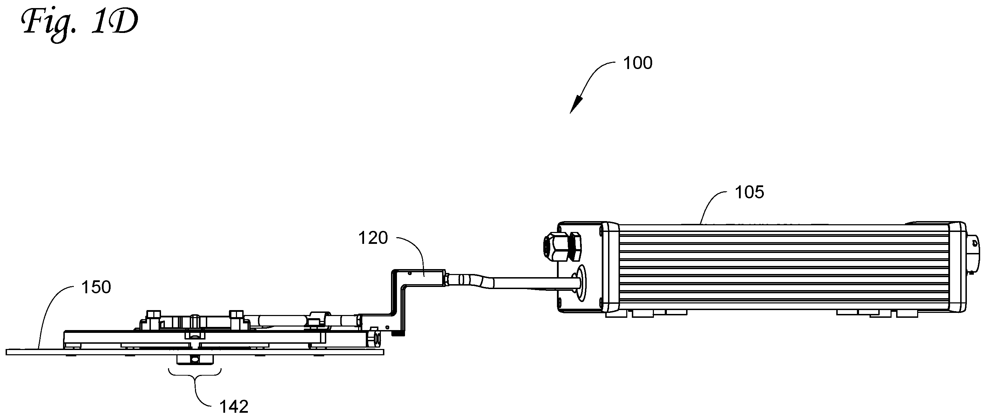

FIGS. 1A and 1B show different features of a wafer test assembly, in accordance with at least one non-limiting example embodiment as described and recited herein. FIG. 1C shows a top view of a wafer test assembly and FIG. 1D shows a side view of the assembled wafer test assembly, also in accordance with at least one non-limiting example embodiment as described and recited herein. The features of each respective one of FIGS. 1A - 1D may be referenced with regard to any others of FIGS. 1A - 1D.

The composite of wafer test assembly 100, as shown in the top view of FIG. 1C and the side view of FIG. 1D, generally includes gas heater assembly 105, which has a gas inlet port 110 and a return gas port 115; a rigid gas manifold 120, which is connected to a cap 140 by gas line 130; a return gas line 135, which connects cap 140 to rigid gas manifold 125; a probe card 145; stiffener 147; and a probe card interface 150.,

Gas heater 105 refers to a heater for a wafer testing assembly that is configured to receive gas, *e.g.,* air, nitrogen, *etc.,* from a separate gas source. Gas heater 105 is further configured to heat and output heated gas to a pressurized region 142 that is at or beneath cap 140, via gas inlet port 110 and rigid gas manifold 120. Gas heater 105 is configured further still to receive at least a sampling of return gas from cap 140, *i.e.,* from the pressurized region 142 at or under cap 140, via gas return line 130, rigid return gas manifold 125, and return gas port 115.

The sampling of gas returned to gas heater assembly 105 via, at least, rigid return gas manifold 125, allows the pressure and/or temperature of the gas output to cap 140 to be monitored. In conjunction with other testing components by which high voltage may be applied to the DUT, performance of the DUT based on temperature and/or pressure may be monitored by a controller that is disposed within or external to gas heater assembly 105. The controller may be further configured to adjust the temperature and/or pressure of the gas applied to cap 140 based on the monitored performance of the DUT.

As an example of the performance testing of the DUT, as high voltage may be applied to a wafer disposed at cap 140, temperature and/or pressure conditions corresponding to a breakdown voltage of the DUT may be determined. In accordance with Paschan's law, by increasing the pressure in pressurized region 142 under or at the DUT, *i.e.,* at card 140, arcing within the testing environment at cap 140, is suppressed and the breakdown voltage of the DUT increases.

Rigid gas manifold 120 and rigid return gas manifold 125 are separate conduits that facilitate, respectively, the transmission of heated air to pressurized region 142 beneath or at cap 140 and the return of at least a pressurized sampling of the heated gas from pressurized region 142 in a manner that does not impact a required stability, *i.e.,* motionless, of the wafer test assembly. Therefore, to provide such rigid stability in accordance with at least one non-limiting example embodiment, rigid gas manifold 120 and rigid return gas manifold 125 are insulated by, *e.g.,* a polytetrafluoroethylene (PFTE) polymer to thereby limit thermal transfer from the manifold to pressurized area 142 and to also reduce expansion of other components of the wafer test assembly during the transfer of the heated and pressurized gas.

Stiffener 147 is provided on a top side of probe card interface 150 to provide supplemental rigidness and stability to reduce deflection of probe card 145 when heated and/or pressurized gas is redirected into pressurized region 142.

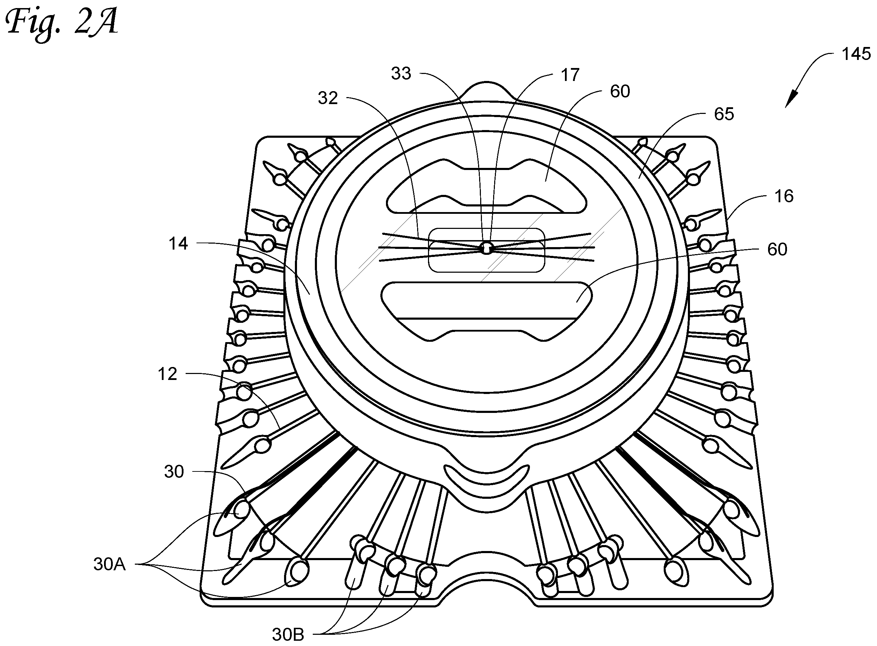

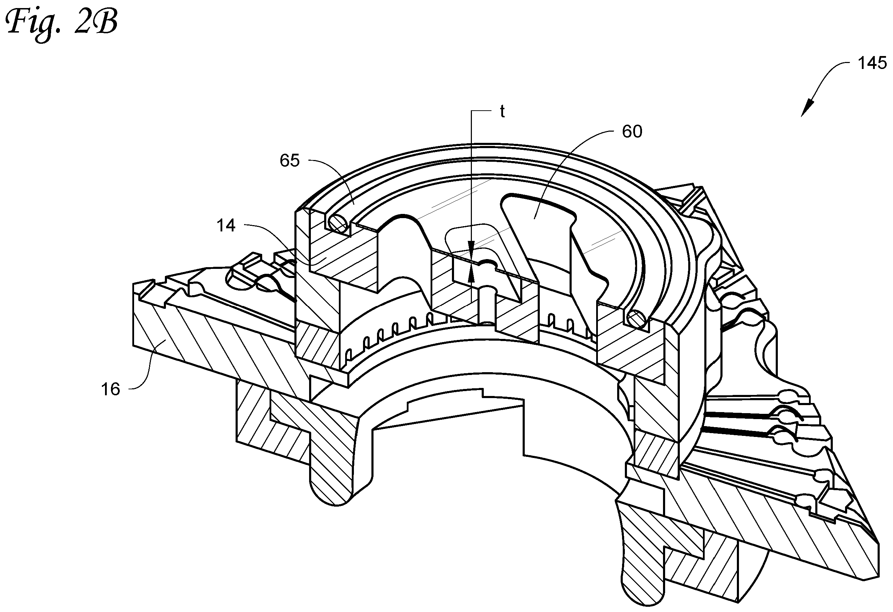

FIGS. 2A and 2B show an embodiment of a probe card assembly, as part of a wafer test assembly, to test, *e.g.,* semiconductor wafers or other MEMS devices. Generally, a circuit board and a probe card can be used to electrically probe a semiconductor device, such as a semiconductor wafer. The probe card contacts the circuit board. The probe card has probe wires that can probe the device to be tested and transmit signals from the probe card to the circuit board. The circuit board transmits signals from the probe card for example to other testing equipment.

An embodiment of probe card 145 is shown in FIGS. 2A and 2B, in which pressurized area 142 is formed and on which cap 140 is accommodated. Probe card 145 includes wire guide 16, which is connected to probe tile 14. Wire guide 16 provides a groove pattern 12 for probe wires to be configured into a contact pattern for example, for contacting a circuit board.

Probe wires 30, which are supported by wire guide 16 and probe tile 14, include probe wires 30A and 30B. Probe wires 30A are generally arranged at corners of probe card 145 and extend a distance further from the center of probe card 145 than a distance of probe wires 30B from the center of probe card 145. That is, probe wires 30B have a smaller radius than probe wires 30A. Probe wires 30A may be referred to as high voltage probe wires 30A, while probe wires 30B may be referred to as low voltage probe wires 30B.

Probe wires 30A have a specific orientation so that a standard probe card, *i.e.,* one not intended for high voltage testing, does not inadvertently receive a high voltage. In such a situation, the standard probe card would not contact the high voltage source on the circuit board. Probe wires 30 provide a probing function of probe card 145, thus each probe wire 30 includes a probe needle 32 with a probe tip 33 that extends through the probe tile 14. For example, the probe needles 32 and tips 33 may be disposed toward the center of the probe tile 14, where the tips are exposed from the probe tile 14 generally at the center of the probe tile 14, such as at opening 17.

Each of probe wires 30 includes a signal transmitting portion and an optional guard portion exposed from the wire guide 16. The signal transmitting portions and the guard portions form a contact pattern on one side of the probe card 145 within the groove pattern 12 of the wire guide 16. The contact pattern of the signal transmitting portions and the guard portions, matches the contact pattern of a circuit board.

Further description and illustration of a wire guide, probe tile, and probe wires is in pending US Patent No. 8,674,715, the entirety of which is incorporated by reference herein. In an embodiment, the probe tile 14 is constructed of a different material than the wire guide 16. For example, the probe tile 14 is a dielectric material and may be composed of a ceramic material for example.

The probe card 145 also includes a connector structure on the other side on which groove pattern 12 of the wire guide 16 is located, and thus the other side from where the contact pattern of the probe wires 30 is formed.

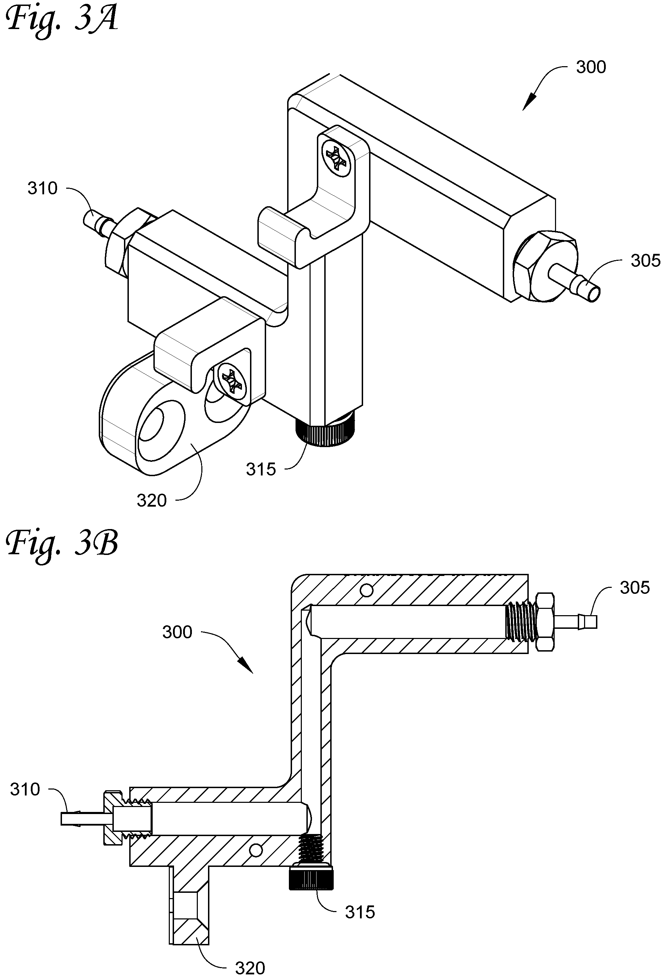

As shown in FIGS. 3A and 3B, rigid manifold 300 represents a non-limiting example embodiment of both rigid gas manifold 120 and rigid return gas manifold 125, shown and discussed throughout this disclosure regarding FIGS. 1A - 1D. Therefore, reference may be made to rigid manifold 300 in place of either rigid gas manifold 120 or rigid return gas manifold 125.

Rigid manifold 300 is configured as a conduit composed of a rigid material, *i.e.,* aluminum, having strong heat stability that is to facilitate the redirection of heated and/or pressurized air. Further, in accordance with non-limiting example embodiments of a wafer test assembly, rigid manifold 300 is configured to conduit or redirect heated and/or pressurized air from one plane to another. For example, as shown in FIGS. 3A and 3B, plug 315 is disposed to seal a cross-drilled hole that connects elevated gas port 305 and lower gas port 310.

With reference to features shown in all of FIGS. 1A - 1D, 2A, 2B, 3A, and 3B, gas port 305 corresponding to rigid gas manifold 300 may be configured to have a leak-free seal with gas inlet port 110 of gas heater 105 to redirect heated and/or pressurized gas, *e.g.,* air or nitrogen, from gas heater 105 to cap 140. As shown in FIGS. 3A and 3B, gas port 305 of rigid gas manifold 300 is at a plane that is elevated relative to gas port 310 that has a leak-free seal with gas line 130 leading to, *e.g.,* pressurized area 142 at or under cap 140, at which the DUT is disposed.

Further, also with reference to all of FIGS. 1A - 3B, gas port 310 of rigid return gas manifold 300 is configured to have a leak-free seal with return gas line 135 to thereby redirect a portion of the heated and/or pressurized gas from pressurized region 142 at or under cap 140 through rigid gas manifold 125 and gas port 305 to a controller corresponding to gas heater 105. At the controller, the temperature and/or pressure of the gas output to pressurized area 142 at or under cap 140 and redirected via rigid gas manifold 300 is monitored for performance testing of the DUT.

With reference to FIGS. 1A, 1B, 3A, and 3B, the rigid manifold configuration of rigid gas manifold 120 and rigid return gas manifold 125, exemplified by rigid manifold 300 in FIGS. 3A and 3B, allow for variance in testing equipment, *e.g.,* gas heater 105, and/or testing parameters, *e.g.,* temperature and/or pressure of gas from gas heater 105. For example, gas heater 105 may be exchanged for other equipment as rigid gas manifold 120 may be disconnected from gas inlet port 110 and rigid return gas manifold 125 may be disconnected from return gas port 115.

Also, the rigid construction or configuration of the manifolds allows for rigid gas manifold 120 and rigid return gas manifold 125 to be connected to gas heater 105 that is external to an enclosure of a portion of the wafer testing assembly to redirect gas to and from an probe card assembly that is internal to an enclosure of a portion of the wafer testing assembly.

Accordingly, the configuration of dual manifolds, *i.e.,* rigid gas manifold 120 and rigid return gas manifold 125 facilitates implementation of simultaneous arc suppression by the redirection of heated and/or pressurized gas into probe card assembly 145 as well as test head probing by redirecting a portion of the pressurized gas from pressurized region 142 back to the controller corresponding to gas heater 105.

That is, improvement and efficiencies in wafer testing are provided by redirecting a heated gas from an external source into a closed probe card assembly via a rigid gas manifold to create a pressurized region proximate to a DUT, with the heated gas being injected within a range of pressure and temperature to increase arc suppression on the DUT, and returning a sampling of the heated gas from the pressurized region to a controller device external to the closed probe assembly via a rigid return gas manifold, with the pressure and the temperature of the heated gas being monitored at the controller.

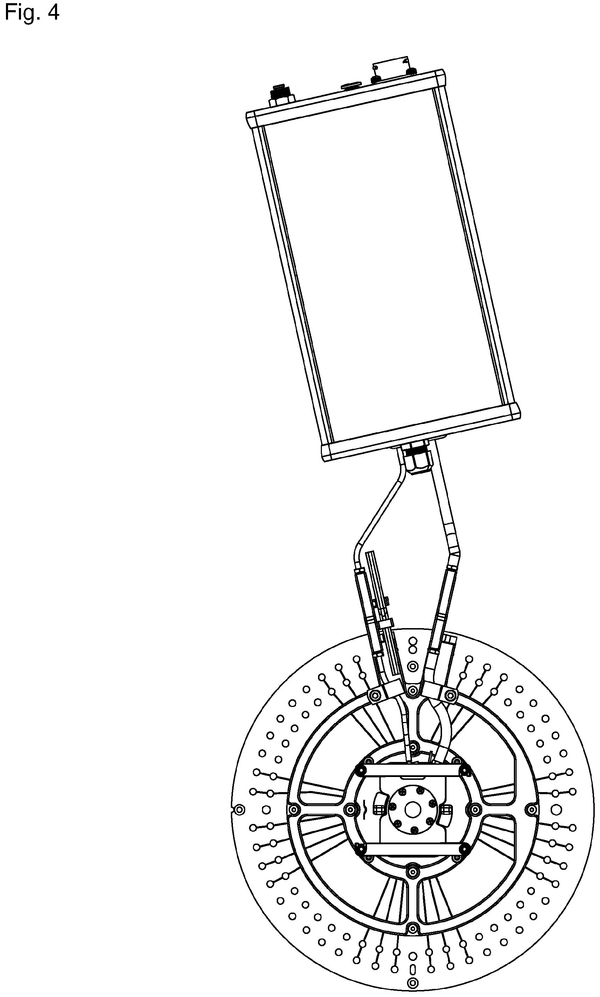

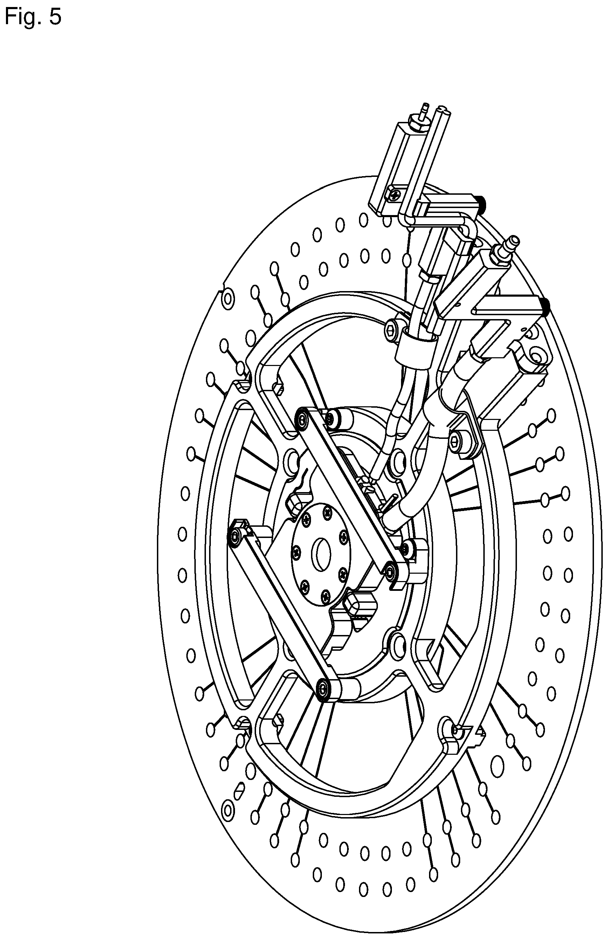

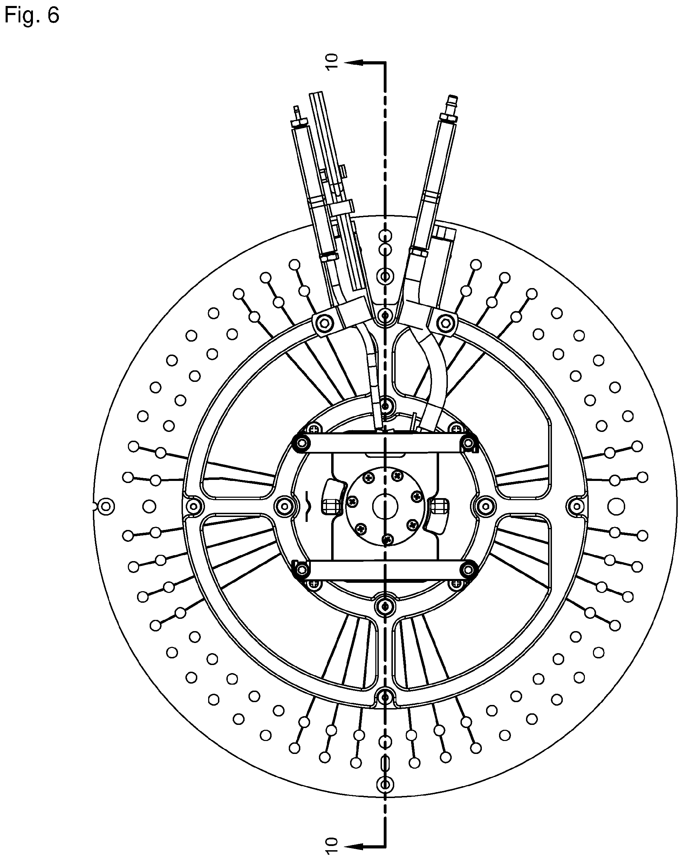

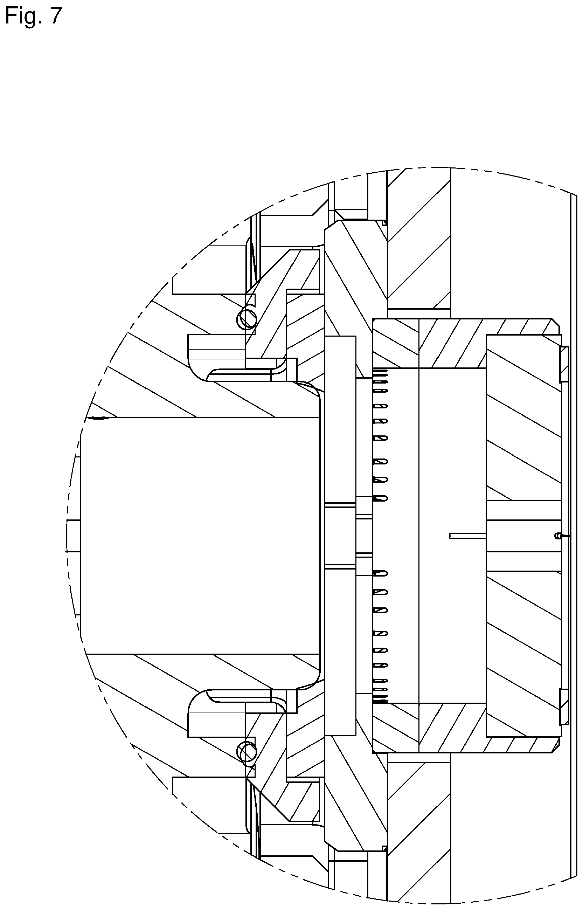

Figs. 4 to 7 are provided to show other views of the wafer test assembly and environment.

### ASPECTS

In the following several aspects of the invention are described.

Aspect 1. A wafer test assembly, comprising:
a probe card assembly, comprising:
   a probe tile configured to accommodate a plurality of openings through which a plurality of voltage-charged probe wires extend;
   a seal disposed on a surface of the probe tile configured to form a pressurized area over at least the probe tile;
a cap configured to securely cover the probe card assembly, the cap including:
   a gas inlet configured to conduit gas into the pressurized area via the plurality of openings of the probe tile, and
   a gas return outlet configured to conduit pressurized gas from the pressurized area;
a rigid gas manifold configured to connect to the gas inlet to redirect gas from a gas heater assembly to the pressurized area; and
a rigid return gas manifold configured to connect to the gas return outlet to return a sampling of the pressurized gas from the pressurized area to the gas heater assembly.

Aspect 2. The wafer test assembly of Aspect 1, further comprising:
the gas heater assembly, which includes:
a heater configured to:
   receive the gas from an external source, and
   heat the gas for redirection to the probe card assembly via at least the rigid gas manifold; and
a controller configured to:
   receive the sampling of pressurized gas via the rigid return gas manifold,
   determine at least one of a temperature of the pressurized gas or a pressure of the pressurized gas based on the received sampling of pressurized gas.

Aspect 3. The wafer test assembly of either Aspect 1 or Aspect 2, wherein the rigid gas manifold and the rigid return gas manifold are disposed external to the probe card assembly.

Aspect 4. The wafer test assembly of any of Aspects 1 to 3, wherein the rigid gas manifold and the rigid return gas manifold are disposed external to the probe card assembly.

Aspect 5. The wafer test assembly of any of Aspects 1 to 4 wherein the heated gas is redirected to the pressurized area from the gas heater assembly via the rigid gas manifold and gas inlet to implement arc suppression on a device under test (DUT).

Aspect 6. The wafer test assembly of any of Aspects 1 to 5, wherein the rigid return gas manifold is structured to connect to the gas return outlet to return a sampling of the pressurized gas from the pressurized area to the gas heater assembly without affecting any movement of the probe card assembly.

Aspect 7. The wafer test assembly of any of Aspects 1 to 6, wherein the gas heater assembly is configured to heat and redirect gas to the probe card assembly via the rigid gas manifold and the gas inlet in correspondence with the plurality of voltage-charged probe wires being charged with a voltage of at least a predetermined testing value.

Aspect 8. The wafer test assembly of any of Aspects 1 to 7, wherein the transmission of gas from the gas heater assembly to the pressurized area via the rigid gas manifold is to implement arc suppression on a device under test (DUT).

Aspect 9. The wafer test assembly of any of Aspects 1 to 8, wherein the wafer test assembly is enclosed and the rigid gas manifold, the rigid return gas manifold, and the gas heater assembly are external to the enclosed wafer test assembly.

Aspect 10. The wafer test assembly of any of Aspects 1 to 9, wherein the gas is air.

Aspect 11. The wafer test assembly of any of Aspects 1 to 10, wherein the gas is nitrogen.

Aspect 12. The wafer test assembly of Aspects 1 to 11, wherein the wafer test assembly is on a lower plane than the gas heater assembly.

Aspect 13. A method of testing performance of a semiconductor device, comprising:
redirecting a heated gas from an external source into a closed probe card assembly via a rigid gas manifold to create a pressurized region proximate to a device under test (DUT),
   wherein the heated gas is injected within a range of pressure and temperature to increase arc suppression on the DUT; and
returning a sampling of the heated gas from the pressurized region to a controller device external to the closed probe assembly via a rigid return gas manifold,
   wherein the pressure and the temperature of the heated gas is monitored at the controller.

Aspect 14. The method of Aspect 13, wherein the range of temperature is between 25° to 200°C.

Aspect 15. The method of Aspect 13 or Aspect 14, wherein the range of pressure is between 30 - 50 PSI.

Aspect 16. The method of any of Aspects 13 to 15,
wherein the redirecting of the heated gas includes injecting the heated gas into a source opening of the rigid manifold and outputting the heated gas from an output opening into a conduit corresponding to the closed probe card assembly,
wherein further the output opening is on a lower plane than the source opening of the rigid manifold.

It should be noted at this point that all of the parts and aspects, in particular the Aspects 1 to 15, described above, and any detail in the figures, individually and in any combination are disclosed as part of an invention and as separate inventive concept.

It is pointed out that the aim of this disclosure is to achieve the broadest possible scope of protection. In this respect, the disclosure contained in the claims can also be specified by features that are described with further features (even without these further features necessarily being included). It is explicitly pointed out that round brackets and the term "in particular" are intended to emphasize the optionality of features in the respective context (which does not mean, conversely, that a feature is to be regarded as mandatory in the corresponding context without such identification). The term "element/element" is preferably intended to characterize a respective coherent structure (or assembly), which in turn can be connected to at least one other structure (to form a possibly one-piece and/or non-movable overall structure) or can be delimited from all other structures.

## Claims

1. A wafer test assembly, comprising:
a probe card assembly, comprising:
a probe tile configured to accommodate a plurality of openings through which a plurality of voltage-charged probe wires extend;
a seal disposed on a surface of the probe tile configured to form a pressurized area over at least the probe tile;
a cap configured to securely cover the probe card assembly, the cap including:
a gas inlet configured to conduit gas into the pressurized area via the plurality of openings of the probe tile, and
a gas return outlet configured to conduit pressurized gas from the pressurized area;
a rigid gas manifold configured to connect to the gas inlet to redirect gas from a gas heater assembly to the pressurized area; and
a rigid return gas manifold configured to connect to the gas return outlet to return a sampling of the pressurized gas from the pressurized area to the gas heater assembly.

2. The wafer test assembly of Claim 1, further comprising:
the gas heater assembly, which includes:
a heater configured to:
receive the gas from an external source, and
heat the gas for redirection to the probe card assembly via at least the rigid gas manifold; and
a controller configured to:
receive the sampling of pressurized gas via the rigid return gas manifold,
determine at least one of a temperature of the pressurized gas or a pressure of the pressurized gas based on the received sampling of pressurized gas.

3. The wafer test assembly of Claim 1 or 2, wherein the rigid gas manifold and the rigid return gas manifold are disposed external to the probe card assembly.

4. The wafer test assembly of any one of Claims 1 to 3, wherein the heated gas is redirected to the pressurized area from the gas heater assembly via the rigid gas manifold and gas inlet to implement arc suppression on a device under test (DUT).

5. The wafer test assembly of any one of Claims 1 to 4, wherein the rigid gas manifold is structured to stably redirect gas from a gas heater assembly to the gas inlet without affecting any movement of the probe card assembly.

6. The wafer test assembly of any one of Claims 1 to 5, wherein the rigid return gas manifold is structured to connect to the gas return outlet to return a sampling of the pressurized gas from the pressurized area to the gas heater assembly without affecting any movement of the probe card assembly.

7. The wafer test assembly of one of Claims 1 to 6, wherein the gas heater assembly is configured to heat and redirect gas to the probe card assembly via the rigid gas manifold and the gas inlet in correspondence with the plurality of voltage-charged probe wires being charged with a voltage of at least a predetermined testing value.

8. The wafer test assembly of any one of Claims 1 to 7, wherein the transmission of gas from the gas heater assembly to the pressurized area via the rigid gas manifold is to implement arc suppression on a device under test (DUT).

9. The wafer test assembly of any one of Claims 1 to 8, wherein the wafer test assembly is enclosed and the rigid gas manifold, the rigid return gas manifold, and the gas heater assembly are external to the enclosed wafer test assembly.

10. The wafer test assembly of any one of Claims 1 to 9, wherein the gas is air.

11. The wafer test assembly of any one of Claims 1 to 9, wherein the gas is nitrogen.

12. The wafer test assembly of any one of Claims 1 to 11, wherein the wafer test assembly is on a lower plane than the gas heater assembly.

13. A method of testing performance of a semiconductor device, comprising:
redirecting a heated gas from an external source into a closed probe card assembly via a rigid gas manifold to create a pressurized region proximate to a device under test (DUT),
wherein the heated gas is injected within a range of pressure and temperature to increase arc suppression on the device under test (DUT); and
returning a sampling of the heated gas from the pressurized region to a controller device external to the closed probe assembly via a rigid return gas manifold,
wherein the pressure and the temperature of the heated gas is monitored at the controller.

14. The method of Claim 13, wherein the range of temperature is between 25° to 200°C and wherein the range of pressure is between 30 - 50 PSI.

15. The method of Claim 13 or 14,
wherein the redirecting of the heated gas includes injecting the heated gas into a source opening of the rigid manifold and outputting the heated gas from an output opening into a conduit corresponding to the closed probe card assembly,
wherein further the output opening is on a lower plane than the source opening of the rigid manifold.
